# EUROPEAN PATENT APPLICATION

(11) **EP 4 739 048 A1**
(43) Date of publication of application: **06.05.2026**
(21) Application number: 25211655.3
(22) Date of filing: 28.10.2025
(51) Int. Cl.: H10H 29/856, H10H 29/85

(54) **TRANSMISSIVE DISPLAY AND LIGHT-EMITTING STRUCTURE**

(30) Priority: 05.11.2024 JP 2024193874
(71) Applicant: Alps Alpine Co., Ltd., Ota-ku, Tokyo 145-8501 (JP)
(72) Inventor: Yoshii, Katsumasa, Iwaki-city, Fukushima (JP); Umagami, Tomomi, Iwaki-city, Fukushima (JP)
(74) Representative: Schmitt-Nilson Schraud Waibel Wohlfrom Patentanwälte Partnerschaft mbB

(57) **Abstract**

A light-emitting structure of a transmissive display includes a plurality of pairs of electrodes arranged in an array, a plurality of transmissive light sources arranged to extend between the electrodes of respective pairs, and a reflective portion arranged in a target region including a region configured for shielding a light path, the light path extending in a direction from a portion of a rear surface of each of the plurality of light sources that faces a gap between the electrodes toward a transparent substrate.

## Description

The present disclosure relates to a transmissive display and a light-emitting structure.

Transmissive displays, which are designed to allow the background to be seen through them unlike conventional displays, are known. In a transmissive display, a plurality of light sources are arranged in an array on a transparent substrate, and a plurality of apertures in which electrodes or the like are not arranged are provided, so that light can be transmitted from the rear surface to the front surface of the display through the apertures. An aperture ratio is a proportion of the aperture area relative to the total pixel area. A higher aperture ratio allows more background light to pass through, enabling the display to appear more transparent to the human eye.

Among various types of transmissive displays, transmissive LED displays are expected to be applied to various applications because the transmissive LED displays can achieve a high transmittance of 70% or more. To construct a transmissive LED display, it is preferable to use a technology called micro-LED in which LEDs used as light sources are miniaturized and arranged in an array.

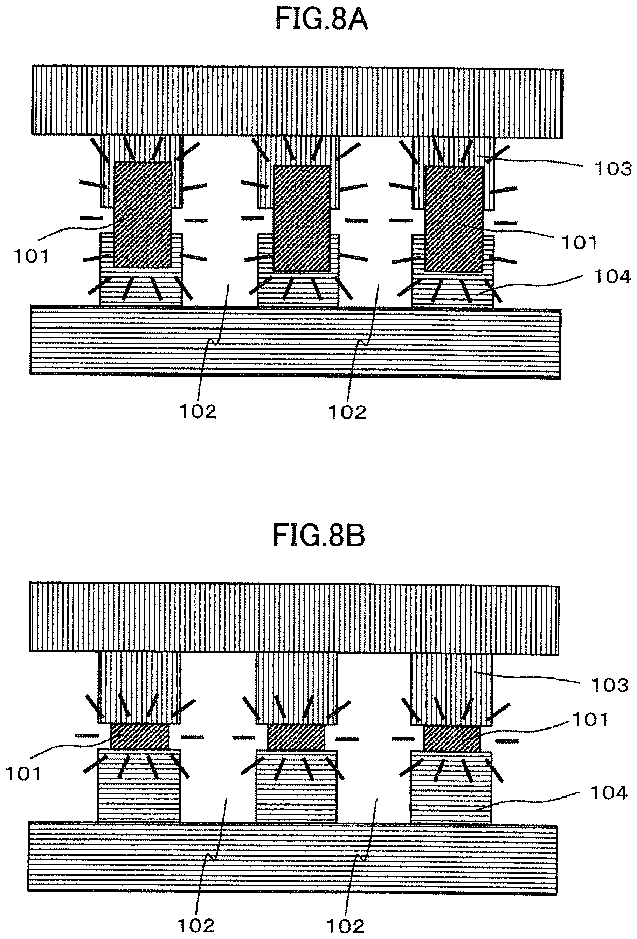

FIGS. 8A and 8B are diagrams simply illustrating the structure of a light emitter of a transmissive LED display. FIG. 8A illustrates a state of the light emitter of the transmissive LED display as seen from the front surface, and FIG. 8B illustrates a state of the light emitter of the transmissive LED display as seen from the rear surface. As illustrated in FIG. 8A, a plurality of LEDs 101 are arranged in an array, and a plurality of apertures 102 are arranged in an array adjacent to the plurality of LEDs 101. The plurality of LEDs 101 are arranged to extend between respective anode electrodes 103 and cathode electrodes 104.

There is a known technology in which an interconnect pattern of a circuit board on which LED chips are mounted is made of a material having light reflectivity (for example, aluminum), so that light emitted from the rear surface of the LED chips can be extracted from the front side (for example, see JP 2012-204370A).

The present disclosure relates to a light-emitting structure and a transmissive display according to the appendant claims. Embodiments are disclosed in the dependent claims.

A light-emitting structure for a transmissive display according to an aspect of the present disclosure includes a plurality of pairs of electrodes arranged in an array, a plurality of transmissive light sources arranged so as to extend between the electrodes of respective pairs, and a reflective portion arranged in a target region including a region configured for shielding a light path, the light path extending in a direction from a portion of a rear surface of each of the plurality of light sources that faces a gap between the electrodes toward a transparent substrate.
FIGS. 1A and 1B are diagrams illustrating a configuration example of a light-emitting structure of a transmissive LED display according to a first embodiment;
FIGS. 2A and 2B are diagrams for explaining an effect of the light-emitting structure according to the first embodiment;
FIGS. 3A and 3B are diagrams illustrating a configuration example of a light-emitting structure of a transmissive LED display according to a second embodiment;
FIGS. 4A and 4B are diagrams illustrating a configuration example of a light-emitting structure of a transmissive LED display according to a third embodiment;
FIGS. 5A and 5B are diagrams illustrating a configuration example of a light-emitting structure of a transmissive LED display according to a fourth embodiment;
FIGS. 6A and 6B are diagrams illustrating a configuration example of a light-emitting structure of a transmissive LED display according to a fifth embodiment;
FIGS. 7A and 7B are diagrams illustrating a configuration example of a light-emitting structure of a transmissive LED display according to another embodiment; and
FIGS. 8A and 8B are diagrams illustrating a structure of a light emitter of a transmissive LED display.

In the transmissive LED display configured in the manner illustrated in FIGS. 8A and 8B, light emitted from the LEDs 101 for being projected onto the front surface leaks to the rear surface through gaps between the anode electrodes 103 and the cathode electrodes 104 as illustrated in FIG. 8B. However, light emitted from the LEDs 101 toward the rear surface, which is different from the observation surface on the front side, is undesirably emitted directly to the rear surface of the transmissive LED display, and becomes lost light that does not contribute to the luminance on the observer side.

In other words, a micro-LED device is generally made by growing a semiconductor thin film on a sapphire substrate by epitaxial growth. Since sapphire and the semiconductor thin film are highly transmissive, light emitted from the inside of the device radiates in all directions. In the transmissive LED display, both the substrate arranged on the front side and the substrate arranged on the rear side of the LED 101 are made of a transparent substrate. When the LED 101 is turned on, light passing through the gap between the electrodes 103 and 104 from the back surface of the LED 101 further passes through the transparent substrate and leaks to the rear surface of the display. Light leakage toward the rear surface results in reduced light utilization efficiency and decreased luminance on the observation surface.

The present disclosure has been made in order to address one or more of these problems, and it is an object of the present disclosure to suppress, in a transmissive display, a decrease in luminance on an observation surface caused by light emitted toward the rear surface of the display through a gap between electrodes when a light source is turned on.

According to aspects of the above-described configuration of the present disclosure, when configured in a transmissive display, when the light source is turned on, light emitted in a direction from the rear surface of the light source toward the transparent substrate is reflected by the reflective section and becomes light toward the observation surface, and it is thereby possible to suppress a decrease in luminance on the observation surface due to light emitted toward the rear surface of the display through the gap between the electrodes.

Embodiments of the present disclosure will be described below with reference to the drawings. A display to which each of the embodiments described below may be applied is a transmissive display in which a plurality of light sources are arranged between a plurality of pairs of electrodes arranged in an array on a transparent substrate and a plurality of apertures in which no electrodes are arranged are provided so that light can be transmitted through the plurality of apertures. In each embodiment, a light-emitting structure is applied to a transmissive LED display using a translucent micro-LED element as an example of a light source to suppress a decrease in luminance on an observation surface.

### (First Embodiment)

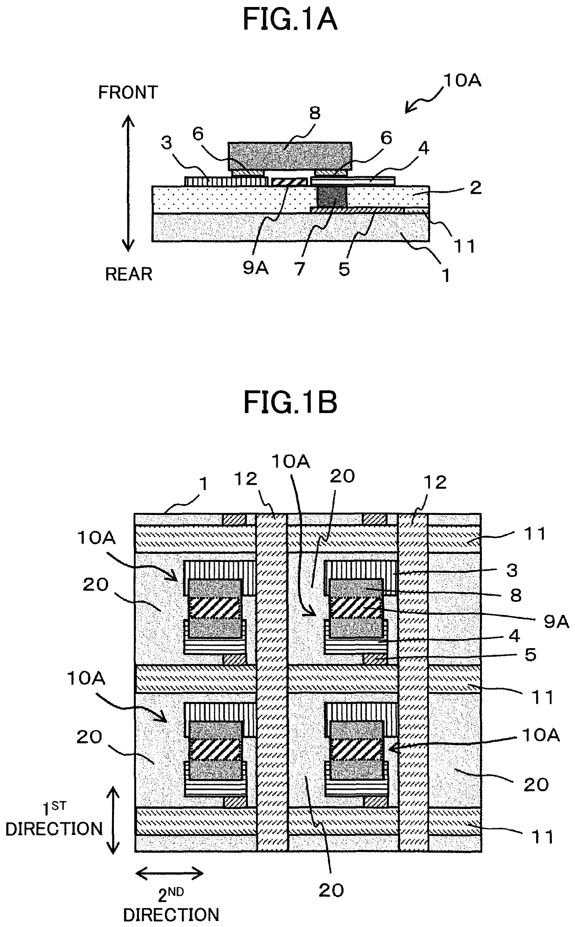

FIGS. 1A and 1B are diagrams illustrating a configuration example of a light-emitting structure 10A of a transmissive LED display according to the first embodiment. FIG. 1A illustrates a cross-sectional view of a single light-emitting structure 10A, as seen from the side of the transmissive LED display, with the front surface of the display shown in the upper part of the figure and the rear surface shown in the lower part. FIG. 1B illustrates an array arrangement of the light-emitting structures 10A, as seen from the front surface of the transmissive LED display. The vertical direction of FIG. 1B is the first direction, and the horizontal direction is the second direction (the first direction and the second direction will be described later). Although FIG. 1B illustrates four light-emitting structures 10A arranged side by side, in reality, more light-emitting structures 10A are arranged in an array.

As illustrated in FIG. 1A, in a single light-emitting structure 10A, an insulating layer 2 is formed on a transparent substrate 1, and a pair of an anode electrode 3 and a cathode electrode 4 is arranged on the surface of the insulating layer 2 with a predetermined interval between the anode electrode 3 and the cathode electrode 4. An LED 8 is arranged so as to extend between the electrodes 3 and 4 and electrically connected to the electrodes 3 and 4. In the example of FIG. 1A, an electrode pad 6 is arranged on each of the electrodes 3 and 4, and the LED 8 is mounted by a conductive adhesive applied on the electrode pads 6.

An interconnect electrode 5 is formed on the surface of the transparent substrate 1, and the cathode electrode 4 and the interconnect electrode 5 are electrically connected by a contact hole 7. With the insulating layer 2 being interposed, the cathode electrode 4 is an upper electrode and the interconnect electrode 5 is a lower electrode. As illustrated in FIG. 1B, the interconnect electrode 5 is connected to a plurality of common interconnect electrodes 11 extending in the second direction. A plurality of segment interconnect electrodes 12 extend in the first direction perpendicular to the second direction, and an anode electrode 3 is connected to the segment interconnect electrodes 12. The common interconnect electrodes 11 three-dimensionally intersect with the segment interconnect electrodes 12, with the insulating layer 2 being interposed.

As illustrated in FIG. 1B, the transmissive LED display has a matrix-like configuration in which a plurality of pairs of electrodes 3 and 4 are arranged in an array and a plurality of LEDs 8 are arranged so as to extend between the electrodes 3 and 4 of respective pairs, with respect to a stacked structure of the transparent substrate 1 and the insulating layer 2, on which the plurality of common interconnect electrodes 11 extending in the second direction and the plurality of segment interconnect electrodes 12 extending in the first direction are provided. In FIG. 1B, for the sake of explanation, the insulating layer 2, the electrode pads 6, and the contact holes 7 are omitted.

In FIG. 1B, a portion where none of the light-emitting structure 10A, the common interconnect electrodes 11, and the segment interconnect electrodes 12 described above is provided is an aperture 20. Through the aperture 20, light can be transmitted from the rear surface of the transmissive LED display to the front surface, so that the rear surface of the transmissive LED display can be seen through from the front surface.

As illustrated in FIGS. 1A and 1B, the light-emitting structure 10A according to the first embodiment is provided with a reflective portion 9A in a target region including a region for shielding a light path in a direction from the portion of the rear surface of the LED 8 that faces the gap between the electrodes 3 and 4 toward the transparent substrate 1. The reflective portion 9A is a reflective layer made of a metal film formed in the gap between each pair of the electrodes 3 and 4 on the same layer (the front surface of the insulating layer 2) as the layer on which the plurality of pairs of the electrodes 3 and 4 are formed. The metal film may be any metal such as aluminum (Al), nickel (Ni), silver (Ag), or silver-magnesium alloy (AgMg), but is preferably a material exhibiting high reflectance and minimal color change in reflected light.

As illustrated in FIG. 1B, the target region in which the reflective portion 9A of the metal film is formed is a rectangular region that has edges in the first direction connecting the electrodes 3 and 4 and in the second direction perpendicular to the first direction, respectively. The length of the target region in the first direction is equal to or less than the maximum length between the edges of the pair of electrodes 3 and 4 in the first direction or the length of the LED 8 in the first direction, and the length of the target region in the second direction is equal to or less than the length of the pair of electrodes 3 and 4 in the second direction or the length of the LED 8 in the second direction.

The target region is specified to such a size in order to prevent the reflective portion 9 from protruding into the region of the aperture 20 (the same applies to the second embodiment, the third embodiment, and the fifth embodiment, which will be described later). Although the target region is not required to be rectangular and the size is not required to be specified as described above, it is preferable to specify the size as described above from the viewpoint of preventing a decrease in the aperture ratio.

In the first embodiment, since the reflective portion 9A of the metal film is arranged in the gap between the electrodes 3 and 4 in the same layer as the layer on which the electrodes 3 and 4 are formed, the reflective portion 9A must be in a non-contact state with the electrodes 3 and 4 in order to prevent a short circuit. For this reason, the length, in the first direction, of the target region on which the reflective portion 9A is formed needs to be less than the length, in the first direction, of the gap formed between the electrodes 3 and 4, and needs to be arranged so as not to contact or overlap with the electrodes 3 and 4. In order to reduce the size of a gap region in which the reflective portion 9A is absent in the first direction, the length of the target region in the first direction is preferably slightly less than the length, in the first direction, of the gap between the electrodes 3 and 4. On the other hand, the length, in the second direction, of the target region on which the reflective portion 9A is formed is less than the length of the LED 8 in the second direction. In order to reduce the size of a gap region in which the reflective portion 9A is absent in the second direction, the length, in the second direction, of the target region is preferably equal to or slightly less than the length of the LED 8 in the second direction. By forming the reflective portion 9A in this manner, substantially the entire gap between the electrodes 3 and 4 can be closed by the reflective portion 9A, while a short circuit with the electrodes 3 and 4 is prevented.

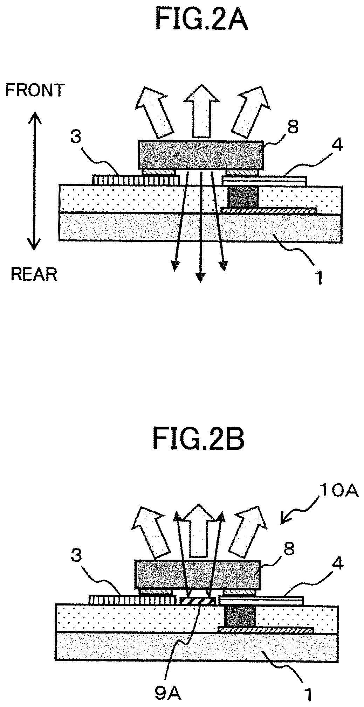

FIGS. 2A and 2B are diagrams schematically illustrating a conventional light-emitting structure and the light-emitting structure 10A according to the present embodiment configured as described above, respectively, for a comparison. FIG. 2A illustrates a conventional light-emitting structure, and FIG. 2B illustrates the light-emitting structure 10A according to the present embodiment. The LED 8 is a micro-LED element, and is composed of sapphire and a semiconductor thin film, both having high transparency. For this reason, as illustrated in FIGS. 2A and 2B, when the LED 8 is turned on, emitted light radiates in all directions, and light is emitted not only from the front surface but also from the rear surface of the LED 8.

In the case of the conventional light-emitting structure illustrated in FIG. 2A, the light emitted from the back surface of the LED 8 toward the transparent substrate 1 leaks to the back surface of the transparent substrate 1 through the gap between the electrodes 3 and 4. On the other hand, in the case of the light-emitting structure 10A of the present embodiment illustrated in FIG. 2B, the light emitted from the rear surface of the LED 8 toward the transparent substrate 1 is reflected by the reflective portion 9A arranged so as to close the gap between the electrodes 3 and 4, and passes through the LED 8 to the observation surface of the transmissive LED display. It is thereby possible to prevent decrease in luminance on the observation surface due to light emitted from the rear surface of the LED 8 toward the rear surface of the transparent substrate 1 through the gap between the electrodes 3 and 4. Thus, it is possible to enhance the light utilization efficiency of the LED 8 and increase luminance on the observation surface.

### (Second Embodiment)

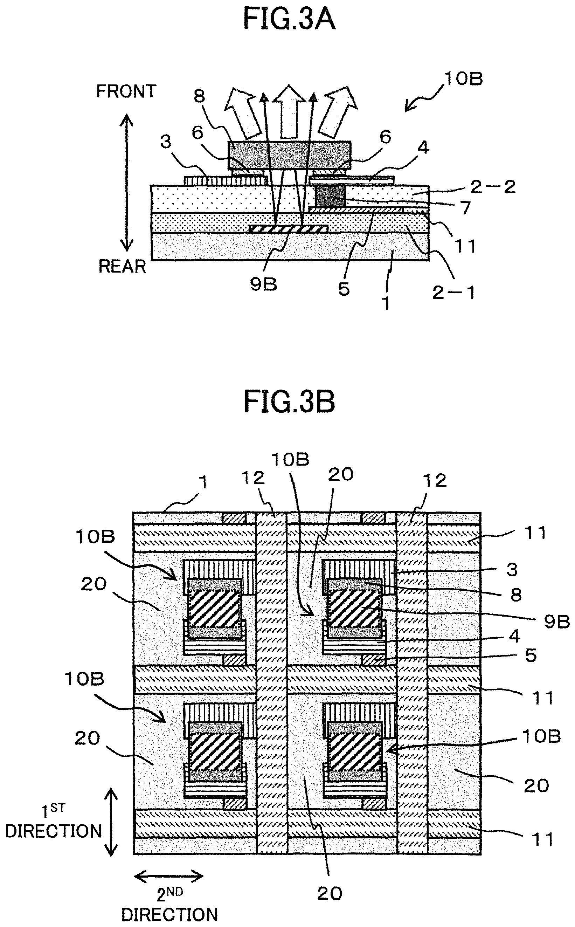

FIGS. 3A and 3B are diagrams illustrating a configuration example of a light-emitting structure 10B of a transmissive LED display according to the second embodiment. FIG. 3A illustrates a cross-sectional view of a single light-emitting structure 10B, as seen from the side of the transmissive LED display, with the front surface of the display shown in the upper part of the figure and the rear surface shown in the lower part. FIG. 3B illustrates an array arrangement of the light-emitting structures 10B, as seen from the front surface of the transmissive LED display. The vertical direction of FIG. 3B is the first direction, and the horizontal direction is the second direction. In FIGS. 3A and 3B, components having the same functions as those illustrated in FIGS. 1A and 1B are denoted by the same reference numerals.

As illustrated in FIG. 3A, in one light-emitting structure 10B, a first insulating layer 2-1 and a second insulating layer 2-2 are formed on the transparent substrate 1, the interconnect electrode 5 is arranged on the front surface of the first insulating layer 2-1, the anode electrode 3 and the cathode electrode 4 are arranged at a predetermined interval from each other on the front surface of the second insulating layer 2-2, and the LED 8 is arranged so as to extend between the electrodes 3 and 4 to be electrically connected. With the second insulating layer 2-2 being interposed, the cathode electrode 4 is an upper electrode and the interconnect electrode 5 is a lower electrode.

As illustrated in FIG. 3B, a plurality of pairs of electrodes 3 and 4 are arranged in an array and a plurality of LEDs 8 are arranged so as to extend between the electrodes 3 and 4 of respective pairs, with respect to a stacked structure of the transparent substrate 1 and the insulating layers 2-1 and 2-2, on which a plurality of common interconnect electrodes 11 extending in the second direction and a plurality of segment interconnect electrodes 12 extending in the first direction are provided. In FIG. 3B, for the sake of explanation, the insulating layers 2-1 and 2-2, the electrode pads 6, and the contact holes 7 are omitted.

As illustrated in FIG. 3A, the light-emitting structure 10B according to the first embodiment is provided, on the light path in a direction from a portion of the rear surface of the LED 8 that faces the gap between the electrodes 3 and 4 toward the transparent substrate 1, with a reflective portion 9B in a target region including a region for shielding this light path. The reflective portion 9B is a reflective layer made of a metal film formed on a layer (the surface of the transparent substrate 1) different from a layer (the surface of the second insulating layer 2-2) on which a plurality of pairs of electrodes 3 and 4 are formed.

As illustrated in FIG. 3B, the target region in which the reflective portion 9B made of a metal film is formed is also a rectangular region, and the length of the target region in the first direction is equal to or less than the greater of the maximum length between the edges of the pair of electrodes 3 and 4 in the first direction or the length of the LED 8 in the first direction, and the length of the target region in the second direction is equal to or less than the greater of the length of the pair of electrodes 3 and 4 in the second direction or the length of the LED 8 in the second direction.

In the second embodiment, since the reflective portion 9B of the metal film is arranged on a layer different from the layer on which the electrodes 3 and 4 are formed, it is not necessary to consider the prevention of a short circuit between the reflective portion 9B and the electrodes 3 and 4, and the size of the reflective portion 9B can be larger than that of the reflective portion 9 of the first embodiment. In the example illustrated in FIGS. 3A and 3B, the length, in the first direction, of the target region in which the reflective portion 9B is formed is greater than the length, in the first direction, of the gap formed between the electrodes 3 and 4 and less than the length of the LED 8 in the first direction. This length of the target region in which the reflective portion 9B is formed may be greater than the length of the LED 8 in the first direction and less than the maximum length, in the first direction, between the edges of the pair of electrodes 3 and 4. On the other hand, the length, in the second direction, of the target region in which the reflective portion 9B is formed may be the same as that of the reflective portion 9 illustrated in the first embodiment.

For example, the length of the target region in the first direction may be set equal to or greater than the length of the gap between the electrodes 3 and 4 in the first direction and equal to or less than the greater of the maximum length between the edges of the pair of electrodes 3 and 4 in the first direction or the length of the LED 8 in the first direction, and the length of the target region in the second direction may be set equal to or greater than the length of the gap between the electrodes 3 and 4 in the second direction and equal to or less than the greater of the length of the pair of electrodes 3 and 4 in the second direction or the length of the LED 8 in the second direction. By forming the reflective portion 9B in such a target region, light leaking from between the electrodes 3 and 4 can be reflected over a wider range, and the light utilization efficiency of the LED 8 can be further enhanced.

### (Third Embodiment)

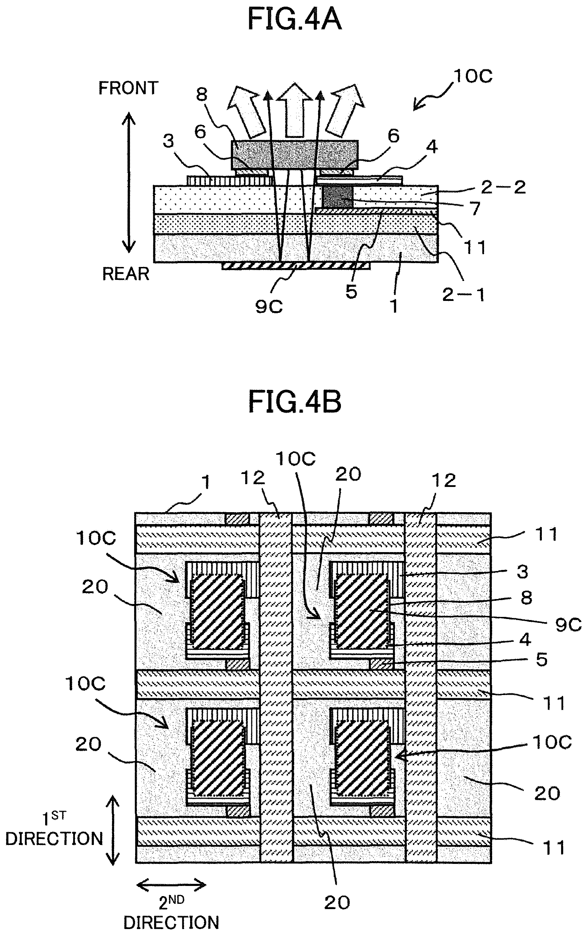

FIGS. 4A and 4B are diagrams illustrating a configuration example of a light-emitting structure 10C of a transmissive LED display according to the third embodiment. FIG. 4A illustrates a cross-sectional view of a single light-emitting structure 10C, as seen from the side of the transmissive LED display, with the front surface of the display shown in the upper part of the figure and rear surface shown in the lower part. FIG. 4B illustrates an array arrangement of the light-emitting structures 10C, as seen from the front surface of the transmissive LED display, the vertical direction of the diagram is the first direction, and the horizontal direction of the diagram is the second direction. In FIGS. 4A and 4B, components having the same functions as those illustrated in FIGS. 3A and 3B are denoted by the same reference numerals.

The light-emitting structure 10C according to the third embodiment has the same structure as that of the second embodiment except for the reflective portion 9C. The reflective portion 9C according to the third embodiment is a reflective layer made of a metal plate, a metal film or a metal sheet formed on a layer (the rear surface of the transparent substrate 1) different from the layer (the front surface of the second insulating layer 2-2) on which the plurality of electrodes 3 and 4 are formed. The reflective portion 9C is attached to the back surface of the transparent substrate 1 by, for example, an adhesive.

In the example illustrated in FIGS. 4A and 4B, the length, in the first direction, of the target region in which the reflective portion 9C is formed is greater than the length, in the first direction, of the LED 8 and less than the maximum length between the edges of the pair of electrodes 3 and 4 in the first direction. In other words, the length is greater than that of the reflective portion 9B illustrated in the second embodiment, but this is only an example. The length in the first direction may be the same as the length of the reflective portion 9B illustrated in the second embodiment. On the other hand, the length, in the second direction, of the target region in which the reflective portion 9C is formed may be the same as that of the reflective portion 9B illustrated in the second embodiment. By forming the reflective portion 9C in this manner, light leaking from between the electrodes 3 and 4 can be reflected over a wider range.

When the reflective portion 9C is arranged on the rear surface of the transparent substrate 1, the distance between the LED 8 and the reflective portion 9C is greater than that in the second embodiment, but the distance can be suppressed to about 1 mm or less. This distance does not affect the image to the extent that blurring due to reflected light occurs, and there is no problem in practice. The first insulating layer 2-1 may be omitted, and only one insulating layer 2 may be formed as in the example illustrated in FIGS. 1A and 1B. In this way, the distance between the LED 8 and the reflective portion 9C can be shortened.

### (Fourth Embodiment)

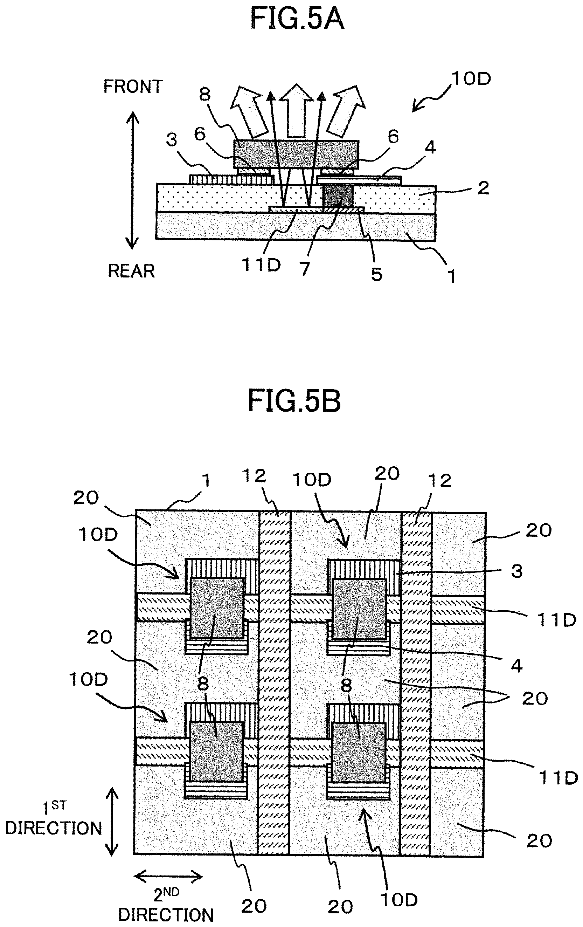

FIGS. 5A and 5B are diagrams illustrating a configuration example of a light-emitting structure 10D of a transmissive LED display according to the fourth embodiment. FIG. 5A illustrates a cross-sectional view of a single light-emitting structure 10D, as seen from the side of the transmissive LED display, with the front surface of the display shown in the upper part of the figure and the rear surface shown in the lower part. FIG. 5B illustrates an array arrangement of the light-emitting structures 10D, as seen from the front surface of the transmissive LED display. The vertical direction of FIG. 5B is the first direction, and the horizontal direction is the second direction. In FIGS. 5A and 5B, components having the same functions as those illustrated in FIGS. 1A and 1B are denoted by the same reference numerals.

In the fourth embodiment, a plurality of common interconnect electrodes 11D extending in the second direction are arranged below (overlap with) the LED 8, and the common interconnect electrodes 11D are used as reflective portions. In other words, in the fourth embodiment, the reflective portions are the common interconnect electrodes 11D formed on the surface of the transparent substrate 1, which is different from the plurality of pairs of electrodes 3 and 4 formed on the surface of the insulating layer 2, and the reflective portions 9A illustrated in FIGS. 1A and 1B are not provided.

As illustrated in FIGS. 5A and 5B, the target region in which the common interconnect electrodes 11D are formed is also a rectangular region, and its length in the first direction is greater than the length of the gap between the electrodes 3 and 4 in the first direction. The common interconnect electrodes 11D extend continuously in the second direction so as to expand between the respective light-emitting structures 10D, and the length of the common interconnect electrodes 11D in the second direction is greater than the length of the gap between the electrodes 3 and 4 in the second direction. By using the common interconnect electrode 11D having a shape such as that of the reflective portion, light leaking from between the electrodes 3 and 4 can be reflected over a wider range. Furthermore, it is possible to omit providing a reflective portion separately from the common interconnect electrode 11D.

### (Fifth Embodiment)

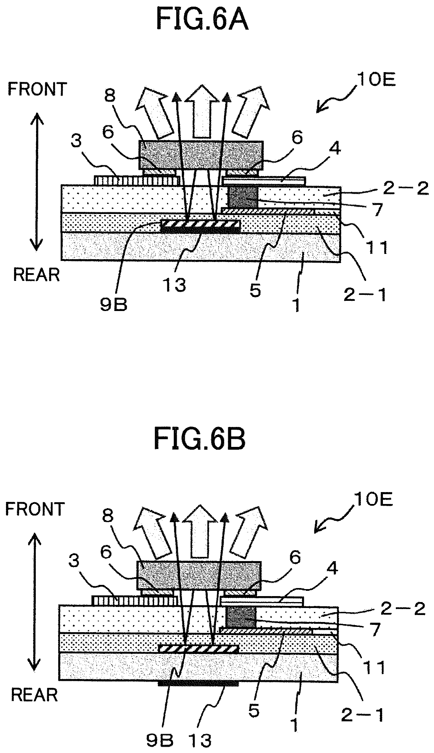

FIGS. 6A and 6B are diagrams illustrating a configuration example of a light-emitting structure 10E of a transmissive LED display according to the fifth embodiment. FIGS. 6A and 6B illustrate two patterns of a configuration of a single light-emitting structure 10E in a cross-sectional view, as seen from the side of the transmissive LED display, with the front surface of the display shown in the upper part of the figures and the rear surface shown in the lower part. The array arrangement of the light-emitting structure 10E as seen from the front surface of the transmissive LED display is the same as that in FIG. 3B. In FIGS. 6A and 6B, components having the same functions as those illustrated in FIGS. 3A and 3B are denoted by the same reference numerals.

The fifth embodiment further includes a light-shielding layer 13 formed at a layer position farther from the reflective portion 9B of the metal film when seen from the LED 8. The light-shielding layer 13 is formed with a shape and size to cover the rear surface of the reflective portion 9B. The plane shape of the light-shielding layer 13 may be the same shape as that of the reflective portion 9, and the plane size of the light-shielding layer 13 may be larger than that of the reflective portion 9B. In FIG. 6A, the light-shielding layer 13 may be, for example, a blackened mask material or a metal film. In FIG. 6B, the light-shielding layer 13 may be, for example, a light-shielding plate, a light-shielding film, or a light-shielding sheet.

The presence of the reflective portion 9B on the surface of the transparent substrate 1 may cause specular reflection light to hit a person behind the display, but this can be prevented by providing the light-shielding layer 13 on the rear side of the reflective portion 9B.

Although FIGS. 6A and 6B illustrate a configuration in which the light-emitting structure 10B of FIGS. 3A and 3B illustrated in the second embodiment is further provided with the light-shielding layer 13, the light-emitting structure 10 of FIGS. 1A and 1B illustrated in the first embodiment or the light-emitting structure 10C of FIGS. 4A and 4B illustrated in the third embodiment may be further provided with the light-shielding layer 13.

### (Other Embodiments)

The first to fifth embodiments are merely examples of embodiments for carrying out the present disclosure, and the technical scope of the present disclosure should not be construed to be limited by them. In other words, it suffices that the light-emitting structure of the present disclosure is provided with a reflective portion in a target region including, on the light path in a direction from a portion of the rear surface of the light-transmitting light source that faces the gap between the electrodes toward the transparent substrate, a region shielding this light path and the present disclosure may be carried out in various forms without departing from the scope of the claims.

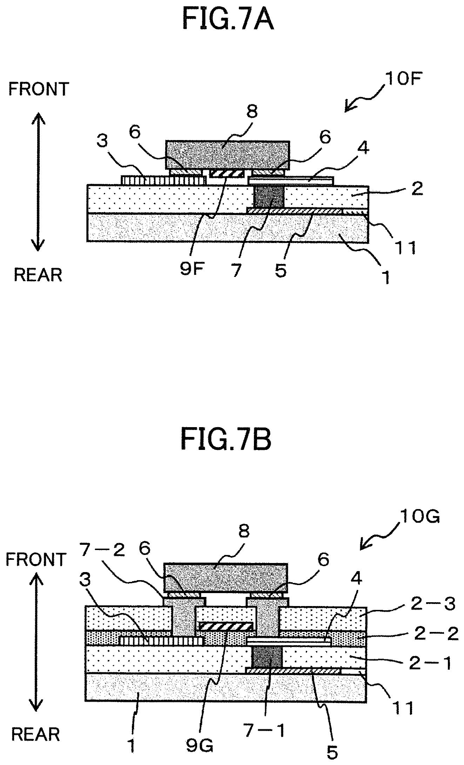

For example, in the above embodiments, a structure in which the reflective portions 9A through 9C are provided at the same layer position as the electrodes 3 and 4 or at a layer position farther away than the layer position when seen from the LED 8 has been described, but a reflective portion may be provided at a layer position closer than the electrodes 3 and 4. For example, as in the light-emitting structure 10F illustrated in FIG. 7A, a reflective portion 9F (e.g., a reflective layer made of a metal plate, metal film or metal sheet) may be arranged on the rear surface of the LED 8. Alternatively, as in the light-emitting structure 10G illustrated in FIG. 7B, the second insulating layer 2-2 and the third insulating layer 2-3 are formed between the electrodes 3 and 4 and the electrode pad 6, the electrodes 3 and 4 are connected to the electrode pad 6 via the second contact holes 7-2 provided in the insulating layers 2-2 and 2-3, and a reflective portion 9G (e.g., a reflective layer made of a metal film) may be provided on the front surface of the second insulating layer 2-2 closer than the electrodes 3 and 4 when seen from the LED 8.

Examples of structures applicable to the light-emitting structure for a transmissive display according to the present disclosure are summarized below.

### [Structure 1]

A light-emitting structure for a transmissive display, the light-emitting structure including: a plurality of pairs of electrodes arranged in an array; a plurality of transmissive light sources arranged so as to extend between the electrodes of respective pairs; and a reflective portion arranged in a target region including a region configured for shielding a light path, the light path extending in a direction from a portion of a rear surface of each of the plurality of light sources that faces a gap between the electrodes toward a transparent substrate.

### [Structure 2]

The light-emitting structure for the transmissive display described in Structure 1 further including a stacked structure including the transparent substrate and an insulating layer, wherein the reflective portion is formed in the gap between the electrodes of each of the pairs on a same layer as a layer on which the plurality of pairs of electrodes are formed.

### [Structure 3]

The light-emitting structure for the transmissive display described in Structure 1 or 2 further including a stacked structure including the transparent substrate and an insulating layer, wherein the reflective portion is formed on a layer different from the layer on which the plurality of pairs of electrodes are formed.

### [Structure 4]

The light-emitting structure for the transmissive display described in Structure 3, wherein the reflective portion is an interconnect electrode different from the plurality of pairs of electrodes.

### [Structure 5]

The light-emitting structure for the transmissive display described in Structure 4, wherein the target region in which the interconnect electrode is formed is a rectangular region having edges in a first direction connecting the electrodes and edges in a second direction perpendicular to the first direction, and a length of the target region in the first direction is greater than a length of the gap between the electrodes in the first direction, and a length of the target region in the second direction is greater than a length of the gap between the electrodes in the second direction.

### [Structure 6]

The light-emitting structure for the transmissive display described in one of Structures 1 to 5, particularly Structure 2 or 3, wherein the reflective portion is a reflective layer formed of a metal film, a metal plate, or a metal sheet.

### [Structure 7]

The light-emitting structure for the transmissive display described in Structure 6, wherein the target region in which the reflective layer is formed is a rectangular region having edges in a first direction connecting the electrodes and edges in a second direction perpendicular to the first direction, a length of the target region in the first direction is equal to or less than a greater of a maximum length between the edges of one pair of electrodes in the first direction or a length of the light source in the first direction, and a length of the target region in the second direction is equal to or less than a greater of a length of one pair of electrodes in the second direction or a length of the light source in the second direction.

### [Structure 8]

The light-emitting structure for the transmissive display described in one of Structures 3 to 7, wherein the reflective portion is a reflective layer formed of a metal film, a metal plate, or a metal sheet, the target region in which the reflective layer is formed is a rectangular region having edges in a first direction connecting the electrodes and edges in a second direction perpendicular to the first direction, a length of the target region in the first direction is equal to or greater than a length of the gap between the electrodes in the first direction, and equal to or less than a greater of a maximum length between the edges of one pair of electrodes in the first direction or a length of the light source in the first direction, and a length of the target region in the second direction is equal to or greater than a length of the gap between the electrodes in the second direction and equal to or less than a greater of a length between the edges of one pair of electrodes in the second direction or a length of the light source in the second direction.

### [Structure 9]

The light-emitting structure for the transmissive display described in any one of Structures 6 to 8, wherein the reflective portion is a metal film formed on a front surface of the transparent substrate or the insulating layer.

### [Structure 10]

The light-emitting structure for the transmissive display described in any one of Structures 6 to 8, wherein the reflective portion is a metal plate, a metal film, or a metal sheet formed on a rear surface of the transparent substrate.

### [Structure 11]

The light-emitting structure for the transmissive display according to any one of Structures 6 to 10 further including a light-shielding layer formed at a layer position farther than the reflective layer from the light source.

### [Structure 12]

A transmissive display comprising the light-emitting structure described in any one of Structures 1 to 11.

## Claims

1. A light-emitting structure for a transmissive display, the light-emitting structure comprising:
a plurality of pairs of electrodes arranged in an array;
a plurality of transmissive light sources arranged so as to extend between the electrodes of respective pairs; and
a reflective portion arranged in a target region including a region configured for shielding a light path, the light path extending in a direction from a portion of a rear surface of each of the plurality of light sources that faces a gap between the electrodes toward a transparent substrate.

2. The light-emitting structure for the transmissive display according to claim 1, the light-emitting structure further comprising:
a stacked structure including the transparent substrate and an insulating layer, wherein
the reflective portion is formed in the gap between the electrodes of each of the pairs on a same layer as a layer on which the plurality of pairs of electrodes are formed.

3. The light-emitting structure for the transmissive display according to claim 1 or 2, the light-emitting structure further comprising:
a stacked structure including the transparent substrate and an insulating layer, wherein
the reflective portion is formed on a layer different from the layer on which the plurality of pairs of electrodes are formed.

4. The light-emitting structure for the transmissive display according to claim 3, wherein
the reflective portion is an interconnect electrode different from the plurality of pairs of electrodes.

5. The light-emitting structure for the transmissive display according to claim 4, wherein
the target region in which the interconnect electrode is formed is a rectangular region having edges in a first direction connecting the electrodes and edges in a second direction perpendicular to the first direction, and
a length of the target region in the first direction is greater than a length of the gap between the electrodes in the first direction, and a length of the target region in the second direction is greater than a length of the gap between the electrodes in the second direction.

6. The light-emitting structure for the transmissive display according to one of claims 1 to 5, wherein
the reflective portion is a reflective layer formed of a metal film, a metal plate, or a metal sheet.

7. The light-emitting structure for the transmissive display according to claim 6, wherein
the target region in which the reflective layer is formed is a rectangular region having edges in a first direction connecting the electrodes and edges in a second direction perpendicular to the first direction,
a length of the target region in the first direction is equal to or less than a greater of a maximum length between the edges of one pair of electrodes in the first direction or a length of the light source in the first direction, and
a length of the target region in the second direction is equal to or less than a greater of a length of one pair of electrodes in the second direction or a length of the light source in the second direction.

8. The light-emitting structure for the transmissive display according to one of claims 3 to 7, wherein
the reflective portion is a reflective layer formed of a metal film, a metal plate, or a metal sheet,
the target region in which the reflective layer is formed is a rectangular region having edges in a first direction connecting the electrodes and edges in a second direction perpendicular to the first direction,
a length of the target region in the first direction is equal to or greater than a length of the gap between the electrodes in the first direction, and equal to or less than a greater of a maximum length between the edges of one pair of electrodes in the first direction or a length of the light source in the first direction, and
a length of the target region in the second direction is equal to or greater than a length of the gap between the electrodes in the second direction and equal to or less than a greater of a length between the edges of one pair of electrodes in the second direction or a length of the light source in the second direction.

9. The light-emitting structure for the transmissive display according to one of claims 6 to 8, wherein
the reflective portion is a metal film formed on a front surface of the transparent substrate or the insulating layer.

10. The light-emitting structure for the transmissive display according to one of claims 6 to 8, wherein
the reflective portion is a metal plate, a metal film, or a metal sheet formed on a rear surface of the transparent substrate.

11. The light-emitting structure for the transmissive display according to one of claims 6 to 10, the light-emitting structure further comprising:
a light-shielding layer formed at a layer position farther than the reflective layer from the light source.

12. A transmissive display comprising the light-emitting structure according to one of claims 1 to 11.
